Europäisches Patentamt

European Patent Office

Office européen des brevets

(11) Publication number: **0 285 869**
**A2**

## (12) EUROPEAN PATENT APPLICATION

(21) Application number: **88104149.5**

(22) Date of filing: **16.03.88**

(51) Int. Cl.⁴: **H03J 9/06 , H03J 5/02**

(30) Priority: **09.04.87 IT 2004287**

(43) Date of publication of application:
**12.10.88 Bulletin 88/41**

(84) Designated Contracting States:
**AT CH DE FR LI NL**

(71) Applicant: **BRIONVEGA S.p.A.**
**Via Pordenone, 8**
**I-20132 Milano(IT)**

(72) Inventor: **Pini, Raffaelio**
**Via Volturno**
**80 Brugherio(Milano)(IT)**

(74) Representative: **Forattini, Amelia et al**
**c/o Internazionale Brevetti Ingg. ZINI,**
**MARANESI & C. S.r.l. Piazza Castello 1**
**I-20121 Milano(IT)**

(54) **A tuning arrangement for the reception of television signals transmitted by earth stations and by satellites.**

(57) A circuit arrangement is described which allows to selectively associate a television signal selection circuit with the tuning assembly for signals broadcast by earth stations or, alternatively, with the tuning assembly for signals broadcast by satellites according to the logical condition set by a first cyclic two-position control while a second cyclic control, which can also assume two logical positions, serves to indicate two possible types of polarization; the arrangement furthermore comprises storage means for storing information related to the tuning of a certain number of preferred signals, be they transmitted by earth stations or by satellites, and means to retrieve said information from said storage means so as to controllably reobtain the tuning of said preferred signals. The possibility is provided of also storing for each of said preferred signals the two logical information items (0 and 1), the first to indicate whether said signal is transmitted by an earth station or by a satellite and the second for the polarization, and means are provided to automatically produce the activation of the satellite tuner, the selection of the polarization, the supply of the related external unit and the reproduction on the television of the video and audio information alternatively to that broadcast by earth stations, upon the retrieval command of said preferred signal.

# A TUNING ARRANGEMENT FOR THE RECEPTION OF TELEVISION SIGNALS TRANSMITTED BY EARTH STATIONS AND BY SATELLITES

This invention relates to a circuit arrangement for the reception of television signals, comprising a first tuning assembly for tuning in to signals broadcast by earth stations and a second tuning assembly for tuning in to signals broadcast by satellites, furthermore comprising a control unit to control the operation of said first tuning assembly.

A system for the reception of satellite television broadcasts essentially comprises a parabolic antenna and a low-noise-figure converter placed outside the building, the output signal whereof, converted to the band 950 to 1750 MHz, and comprising a plurality of television signals, is sent, by means of a cable, to a unit placed within the building and near or inside the television set.

The purpose of this unit, which is known as "internal unit", is to amplify and select a desired signal among the plurality of signals present at its input, and to demodulate it so that it can be fed to the video/audio inputs of the television set or, after remodulation onto a frequency in the earth bands, it can be applied to the antenna input of the television set alternatively to the antenna for "earth" signals.

It is foreseeable that in the future said "internal unit" will be built into newly designed television sets. However, at the present time, in which this service is not widespread, the most common approach, so as to not burden all television sets with a greater cost, is to provide an independent unit external to the television set and connected thereto with suitable cables.

This unit must therefore be provided with a power supply and with a tuning system of its own so as to supply to the satellite assembly the suitable voltages for the selection of the desired channel among the plurality of signals present at its input. These circuits duplicate, in a way, those already existing inside the television set for the selection of the earth channels.

An adequate system must be furthermore provided for switching the signal polarization, since the signals coming from satellites, in order to avoid interference problems, have two different polarizations in adjacent channels: vertical and horizontal, or rightward and leftward.

A drawback of such a system, however, is that the user, in contrast to the case of reception of earth signals with television sets equipped with remote control, is forced to leave his seat to operate this unit every time he wishes to change from the reception of channels broadcast by earth stations to those broadcast by satellites and every time he wishes to select a different satellite-broadcast signal. More advanced designs are also known, where the internal unit is equipped with its own remote control system. However, such systems, beside having a bigger size and cost, also have the disadvantage of requiring a remote control transmitter of their own, with the result that the user has to operate two different remote control transmitters: one to control the various functions of the television set and the selection of the earth television stations, and the other, provided with the satellite tuner, for the tuning and selection of the signals coming from satellites.

Furthermore, the satellite tuner must be placed "within sight" of the user, so that it can receive the infrared-ray signals of satellites. This requirement adversely affects the appearance of the apparatus.

The object of the invention is therefore to provide a circuit arrangement for the reception of television broadcasts from earth stations and from satellites, whereby the user can control both the standard television set and the internal unit, as well as the switching from one to the other, by means of a single, unexpensive and compact remote control transmitter.

In order to achieve the above and other objects, the invention provides a circuit arrangement for the reception of television signals, comprising a first tuning assembly for tuning to signal broadcast by earth stations and a second tuning assembly for tuning to signals broadcast by satellites, furthermore comprising a control unit for controlling the operation of said first tuning assembly, characterized in that circuit means are provided to allow said control unit to also control the operation of said second tuning assembly.

A second characteristic of the circuit arrangement according to the invention is that it allows to associate a selection circuit, according to the logical condition set by a first two-position cyclic control, with said first tuning assembly or, alternatively, with said second tuning assembly.

A third characteristic of the circuit arrangement according to the invention is that it comprises storage means for storing information related to the tuning of a certain number of preferred signals, be they transmitted by earth stations or by satellites, and means for recalling said information from said storage means so as to controllably reobtain the tuning of said preferred signals.

A further characteristic of the circuit arrangement according to the invention is that the possibility is provided of also storing, for each of said preferred signals, two logical information items, corresponding to the states of said first cyclic control and of a second cyclic control, the first to determine whether said signal is transmitted by an earth station or by a satellite and the second to determine the type of polarization.

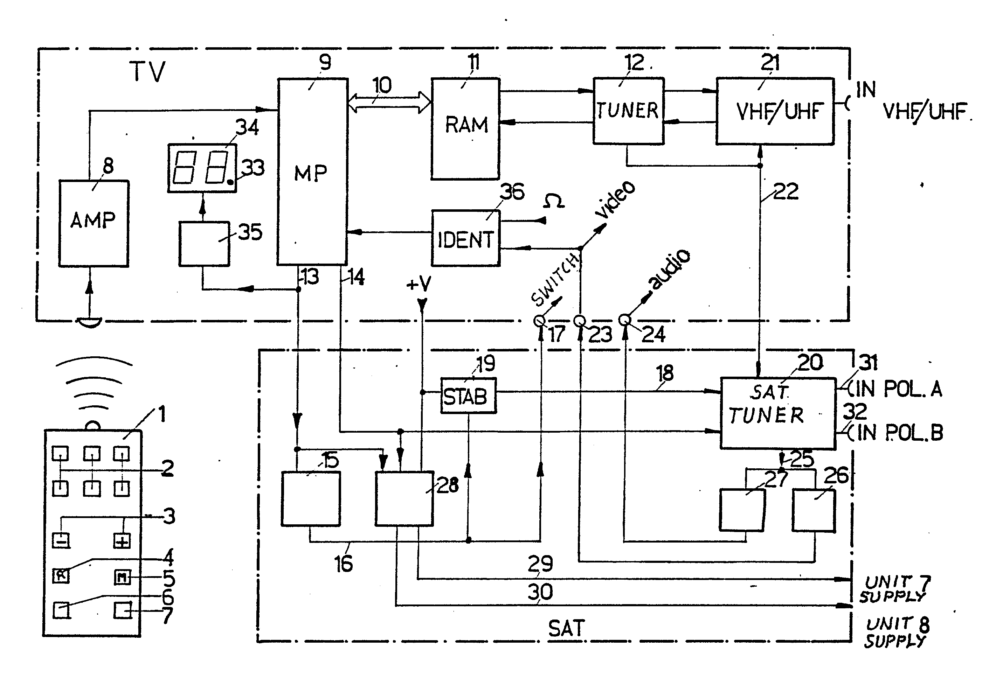

The invention will now be described in detail with reference to the accompanying drawing, given by way of non-limiting example, the single figure whereof is a block diagram of a television set including the circuits according to the invention.

With reference to the figure, a remote control transmitter 1 has conventional keys 2 for program or channel changing, keys 3 for fine tuning correction (-and +), a station search key 4 (R), and a storage key 5 (M), for assigning a desired television channel to each program key, according to the user's choice. According to the invention, the remote control transmitter 1 also has a key 6 for switching between earth and satellite TV and a key 7 for switching between two types of polarization (rightward or leftward, or vertical or horizontal).

A group of circuits shown enclosed in a dash-and-dot box marked TV all relate to the earth station part of the circuit arrangement, while the circuits enclosed in a dash-and-dot box marked SAT relate to the satellite part of the circuit arrangment.

Signals transmitted by remote control 1 are received and amplified by an amplifier 8 and sent for decoding to a microprocessor 9 which is connected by means of a serial three-wire bus 10 to a non-volatile memory 11. Memory 11 is adapted to store a code for each program, and moreover two additional bits, one to indicate whether the program is an earth or satellite one, and the other to indicate the type of polarization of the signal, using as output port the microprocessor 9 which by means of the bus 10 reads the content of the memory 11.

Microprocessor 9 also drives a seven-segment digital display 34 through a conventional coding circuit 35. Storage key 5 has the additional function, as will appear from the following description, of associating with each program one of the logical conditions "0" and "1", as chosen by the user by means of keys 6 and 7. The latter two keys both have a cyclic two-position operation, to which the two logical conditions (0 and 1) correspond, and their status is displayed by using the decimal point 33 of the 7-segment displays 34 which is part of the standard television set for the display of the channel or program number.

The earth station part of the circuit arrangement further comprises: a tuner 12 having bidirectional connections to RAM 11 and to a VHF/UHF demodulator 21 connected to an input IN for the VHF/UHF signals from earth stations. An identification circuit 36 is also connected to a port of microprocessor 9.

In the satellite part of the circuit arrangement (SAT), a satellite signal tuner 20 has two inputs 31, 32, for receiving TV input signals from a satellite antenna (not shown) with polarization A and B, respectively. Tuner 20 is supplied by a controllable voltage stabilizer 19. The video and audio output of tuner 20 are connected through amplifiers 26, 27 to input terminals 23, 24 of the standard television receiver. Two switches 15 and 28 are also provided for purposes that will appear below.

Microprocessor 9 asserts two output ports 13 and 14 for driving switches 15 and 28 for earth/satellite reception and for polarization control, respectively. When the signal on port 13 has the logical value "0", the voltage on the output 16 of electronic switch 15 takes a value of 0 volts and the input for "slow switching" 17 of the television set to which it is connected also assumes the same value.

Similarly, the output voltage 18 of programmable voltage stabilizer circuit 19 which supplies the satellite tuning assembly 20 is also zero. In these conditions, the image displayed on the screen of the television set is that coming from the earth signal tuning assembly 21, for the channel tuned into by the tuning voltage present on the connection 22. According to European standards, a zero voltage on the input of the "slow switching" sets the television receiver to operate so as to display the signals coming from its own radio-frequency chain, i.e., from the VHF/UHF assembly for earth channels.

If, on the other hand, key 6 has been pressed, port 13 assumes the logical value "1", and the voltage on the output 16 of electronic switch 15 becomes + 12 volts and, being connected to the input 17 for the "slow switching" of the television set, causes its switching to operate as "monitor", complying with the applicable European standards.

In this condition, the set no longer displays the signals coming from its own radio frequency chain (i.e., those coming from tuning assembly 21) but the base-band video and audio signals arriving from an external source and respectively applied to the video input 23 and to the audio input 24. Simultaneously, since the voltage on line 16 is equal to + 12 Volts, voltage stabilizer 19 also supplies the supply voltage to satellite tuning assembly 20. The base-band output 25 of the latter is connected through video amplifier 26 to the video input of television set 23 and through audio limiter/demodulator 27 to the audio input of television set 24.

When signal 13 is high, switch 28 is also turned on, and, depending on whether the voltage 14 is high or low, supplies a suitable supply voltage to the output 29 for the supply of the external unit with type A polarization, or alternately to the output 30 for the supply of the external unit with type B polarization (type A polarization being for example the rightward or vertical one and type B being the leftward or horizontal one). The voltage at 14 is also delivered to satellite tuning assembly 20 and, depending on its high or low value, determines which of its two inputs 31 or 32 is active correspondingly to the external unit supplied by means of the switch 28.

The channel tuned into by satellite assembly 20 is the one determined by the value of the tuning voltage 22.

For a better understanding of the operation of the above described circuit arrangement, two modes of operation will now be described:

a) Tuning and storage of signals transmitted by satellites.

If the television set was in the earth signal reception condition, it is first of all necessary to preset it for satellite reception by pressing key 6 of the remote control transmitter. This signal is received and amplified by amplifier 8 and decoded by microprocessor 9. Port 13 thus becomes high, and turns on the decimal point 33 of the 7-segment display 34 by means of circuit 35. The user is thus informed that the television set is in "satellite reception" mode.

Simultaneously, output 16 of switch 15 takes a value of + 12 Volts and drives high input 17 to switch the television set into "Monitor" mode, in which the video and audio signals applied respectively at its inputs 23 and 24 are displayed.

As the next step, key 7 is pressed to select the desired polarization for the satellite signals which are to be received.

The signals received and amplified by amplifier 8 and decoded by microprocessor 9 set the logical condition of port 14 which, via switch 28, supplies one external unit or the other and enables the corresponding input of tuner 20.

The tuning of the signal required among the plurality of those available at the input 31 or 32 of tuner 20 is performed in a fully ordinary manner entirely similar to what is done for "earth" signals, for example by acting on the search key 4.

The associated signal received and amplified by amplifier 8 and decoded by microprocessor 9 generates, through tuner 12, a voltage ramp which is sent through line 22 to the appropriate input of tuner 20.

When, upon a change of the tuning voltage present on line 22, a valid television signal is tuned into, then the search is stopped by the identification circuit 36.

The signal thus received can then, if necessary, be fine-tuned by acting on the fine tuning controls 3.

By pressing storage key 5 and then dialling a certain program number on keys 2, all current data, i.e., the tuning voltage corresponding to the received channel, possible fine tuning correction and logical status of ports 13 and 14, are stored in the non-volatile memory 11 at this address. In a similar manner any other signal having the same polarization can be tuned into and stored. In order to perform the search and storage of the signals having the other polarization, the same steps are repeated after changing the polarization by means of key 7.

b) Retrieval of a previously stored satellite signal.

The program number on which a certain satellite signal had been previously stored in the manner described at a) is dialled.

The signal received and amplified by amplifier 8 is decoded by microprocessor 9 and used to read memory 11 through bus 10. The memory, by means of the interface circuit 12, the tuning voltage corresponding to the desired channel, as stored at that memory location, and simultaneously, via bus 10, causes ports 13 and 14 to take the appropriate value.

By means of the invention the following objects are achieved:

-provide an unexpensive satellite receiver unit which uses the power supply, tuning and remote control systems already existing in the television set; the only variation required with respect to conventional systems is that of having two additional bits for each program memory cell;

-provide a unit of small size and therefore suitable, for example, to be hung on the back of the television set, inasmuch as it does not have to be "within sight" of the user;

-provide a unit that is fully controllable remotely, using the single transmitter already provided with the television set, considerably simplifying the mode of use;

-eliminate the need for programs specifically dedicated to satellite channels in the remote control system of the television set, since it is possible to store an earth signal or a satellite signal on any of the program keys.

It is apparent that the person skilled in the art may make changes in the arrangement described by way of example, without leaving the scope of the invention as claimed. For example, the function of key 6 may be replaced with any programmable cyclic function already available in the set; and/or the functions of the cyclic key 7 can be replaced with a programmable proportional control (of the + and - type) already available in the set such as the volume control, the contrast control or the like, making one logical position correspond to the range limit of the corresponding "-" control and the other logical position correspond to the stroke limit of the corresponding " + " control.

## Claims

1. Circuit arrangement for the reception of television signals, comprising a first tuning assembly (21) for tuning into signals broadcast by earth stations and a second tuning assembly (20) for tuning into signals broadcast by satellites, furthermore comprising a remote control unit (1) for controlling the operation of said first tuning assembly (21), characterized in that it further comprises circuit means (8, 9, 11, 12, 15) enabling said control unit (1) to also control the operation of said second tuning assembly (20).

2. The circuit arrangement of claim 1, wherein said circuit means comprise a selection circuit (15), for enabling said first tuning assembly (21) or, alternatively, said second tuning assembly (20) depending on the logical condition set by a first two-position cyclic control (6).

3. The circuit arrangement of claim 1, wherein a second cyclic control (7), which can also assume two logical positions, selects two possible polarization types (A;B) of the satellite signal.

4. The circuit arrangement of claim 1, further comprising storage means (11) for the storage of information related to the tuning of a desired number of preferred signals, be they broadcast by earth stations or by satellites, and means (1, 8, 9, 10) for retrieving said information from said storage means (11) so as to controllably reobtain the tuning of said preferred signals.

5. The circuit arrangement of claim 2, further comprising storage means for two logical information items, corresponding to the states of said first (6) and of said second (7) cyclic control, the first to indicate whether said signal is broadcast by an earth station or by a satellite and the second to indicate the type of polarization, for each of said preferred signals.

6. The circuit arrangement of claim 5, wherein means (9, 15, 28) are provided to automatically enable the satellite tuner (20), the selection of the polarization, the supply of the related external unit (A;B) and the display on the television set of the video and audio information alternatively to that broadcast by earth stations, upon the retrieval command of said preferred and stored signal.

TV

9 10 11 12 21

MP RAM TUNER VHF/UHF IN VHF/UHF

8 34 33 35

AMP

36 video
IDENT
SWITCH audio
13 14 +V 17 23 24

22

19 18 20 31
STAB SAT IN POL. A
TUNER 32
IN POL. B

15 28 16 25 27 26

29 UNIT 7
SUPPLY
30

SAT UNIT 8
SUPPLY

1 2 3 4 5 6 7

0 285 869